# EUROPÄISCHE PATENTANMELDUNG

(11) **EP 0 956 907 A1**
(43) Veröffentlichungstag der Anmeldung: **17.11.1999**
(21) Anmeldenummer: 99109476.4
(22) Anmeldetag: 12.05.1999
(51) Int. Cl.: B05B 15/00, B65G 69/00, B65G 49/00

(54) **Transportsystem zum Transportieren von Gegenständen in einen Arbeitsraum hinein oder aus einem Arbeitsraum heraus**

(30) Priorität: 13.05.1998 DE 19821338
(71) Anmelder: Dürr Systems GmbH, 70435 Stuttgart (DE); AUDI AG, 85045 Ingolstadt (DE)
(72) Erfinder: Gutjahr, Rolf, 71254 Ditzingen (DE); Raible, Alfred, 72160 Horb (DE); Dintner, Alfons, 85120 Hepberg (DE)
(74) Vertreter: Hoeger, Stellrecht & Partner

(57) **Zusammenfassung**

Um ein Transportsystem zum Transportieren von Gegenständen in einen Arbeitsraum (100) hinein oder aus einem Arbeitsraum (100) heraus zu schaffen, das es ermöglicht, den Eintrag von Staub- und Schmutzteilchen aus dem Außenraum (118) des Arbeitsraums in den Arbeitsraum (100) hinein beim Transportieren der Gegenstände in den Arbeitsraum (100) hinein bzw. aus dem Arbeitsraum (100) heraus zu vermindern, wird erfindungsgemäß ein Transportsystem vorgeschlagen, das einen geschlossenen, transportablen Behälter (142) mit einer verschließbaren Zugangsöffnung (156) und einen Andockbereich (122) umfaßt, der in eine Außenwand (114) des Arbeitsraums (100) integriert ist und eine verschließbare Andocköffnung (122) aufweist, wobei der transportable Behälter (142) von der Außenseite des Arbeitsraums (100) her so mit dem Andockbereich (122) verbindbar ist, daß bei geöffneter Zugangsöffnung (156) und geöffneter Andocköffnung (122) der Innenraum (158) des Behälters (142) von dem Arbeitsraum (100) aus zugänglich und von dem Außenraum (118) des Arbeitsraums (100) getrennt ist.

## Beschreibung

Die vorliegende Erfindung betrifft ein Transportsystem zum Transportieren von Gegenständen in einen Arbeitsraum hinein oder aus einem Arbeitsraum heraus.

Ferner betrifft die vorliegende Erfindung ein Verfahren zum Transportieren von Gegenständen in einen Arbeitsraum hinein oder aus einem Arbeitsraum heraus.

Wird in einem Produktionsbetrieb ein Herstellungs- oder Bearbeitungsschritt in einem geschlossenen Arbeitsraum durchgeführt, so müssen in der Regel Arbeitsmaterialien und -gerätschaften in diesen Arbeitsraum hinein und Abfallstoffe aus dem Arbeitsraum heraus transportiert werden. Ferner ist häufig zu Wartungs- und Reparaturzwecken ein Transport von Vorrichtungen oder Vorrichtungsteilen in den Arbeitsraum hinein und, nach Abschluß der Wartungs- oder Reparaturarbeiten, aus dem Arbeitsraum wieder heraus erforderlich.

Zu diesem Zweck sind üblicherweise in einer Außenwand des Arbeitsraums Türen oder Tore vorgesehen, die im Zuge eines Transportvorgangs geöffnet werden, um die zu transportierenden Gegenstände von dem Außenraum des Arbeitsraums in denselben hinein oder aus dem Innenraum des Arbeitsraums in den Außenraum desselben zu befördern.

Die Verwendung solcher Verbindungstüren zwischen dem Arbeitsraum und dem Außenraum des Arbeitsraums ist Jedoch nachteilig, da bei jedem Öffnen der Verbindungstüren Schmutz- oder Staubteilchen aus dem Außenraum des Arbeitsraums in den Arbeitsraum eingebracht werden und sich auf den Einbauten des Arbeitsraums und den dort vorhandenen Arbeitsgerätschaften absetzen.

Ein solcher Eintrag von Verschmutzungen beim Transport von Gegenständen in den Arbeitsraum hinein oder aus dem Arbeitsraum heraus ist insbesondere dann problematisch, wenn in dem Arbeitsraum Staubschutzbedingungen einzuhalten sind, um die Qualität der dort hergestellten oder bearbeiteten Erzeugnisse zu gewährleisten.

Handelt es sich bei dem Arbeitsraum beispielsweise um einen Arbeitsraum einer Lackieranlage, so besteht die Gefahr, daß der in den Arbeitsraum eingebrachte Staub durch die Bewegung von Personen in dem Arbeitsraum oder beim Transportieren der Gegenstände in dem Arbeitsraum aufgewirbelt wird, sich auf frisch lackierten Teilen niederschlägt und mit dem Lack im Verlauf des Trocknungsprozesses eingebrannt wird. Eine solche Verschmutzung der zu lackierenden Teile macht eine zeitintensive und kostspielige Nacharbeit an den fertig lackierten Teilen erforderlich.

Der vorliegenden Erfindung liegt daher die Aufgabe zugrunde, ein Transportsystem zum Transportieren von Gegenständen in einen Arbeitsraum hinein oder aus einem Arbeitsraum heraus zu schaffen, das es ermöglicht, den Eintrag von Staub- und Schmutzteilchen aus dem Außenraum des Arbeitsraums in den Arbeitsraum hinein beim Transportieren der Gegenstände in den Arbeitsraum hinein bzw. aus dem Arbeitsraum heraus zu vermindern.

Diese Aufgabe wird erfindungsgemäß durch ein Transportsystem zum Transportieren von Gegenständen in einen Arbeitsraum hinein oder aus einem Arbeitsraum heraus gelöst, das folgendes umfaßt:
- einen geschlossenen, transportablen Behälter mit einer verschließbaren Zugangsöffnung und
- einen Andockbereich, der in eine Außenwand des Arbeitsraums integriert ist und eine verschließbare Andocköffnung aufweist,
wobei der transportable Behälter von der Außenseite des Arbeitsraums her so mit dem Andockbereich verbindbar ist, daß bei geöffneter Zugangsöffnung und geöffneter Andocköffnung der Innenraum des Behälters von dem Arbeitsraum aus zugänglich und von dem Außenraum des Arbeitsraums getrennt ist.

Die erfindungsgemäße Lösung ermöglicht es, die zu transportierenden Gegenstände in einer Andockstellung des transportablen Behälters an dem Andockbereich des Arbeitsraums aus dem Innenraum des transportablen Behälters in den Arbeitsraum zu entnehmen oder die zu transportierenden Gegenstände von dem Innenraum des Arbeitsraums aus in den Innenraum des transportablen Behälters einzubringen, nachdem sowohl die Andocköffnung des Andockbereichs als auch die Zugangsöffnung des transportablen Behälters geöffnet worden sind. In dieser Andockstellung ist der Innenraum des Behälters von dem Arbeitsraum aus zugänglich, so daß der Behälter von dem Arbeitsraum aus be- oder entladen werden kann. Jedoch ist der Innenraum des Behälters in der Andockstellung von dem Außenraum des Arbeitsraums getrennt, so daß keine Schmutz- oder Staubteilchen aus dem Außenraum des Arbeitsraums in den Arbeitsraum hinein gelangen können.

Umgekehrt können auch keine Teilchen aus dem Innenraum des Arbeitsraums oder aus dem Innenraum des transportablen Behälters in der Andockstellung in den Außenraum des Arbeitsraums gelangen. Auch dies kann von Bedeutung sein, wenn in dem Arbeitsraum verschmutzte oder kontaminierte Objekte gehandhabt werden und ein Entweichen des Schmutzes oder der Kontamination in den Außenbereich des Arbeitsraums verhindert werden soll.

Das erfindungsgemäße Transportsystem kann überall dort zum Einsatz kommen, wo ein Austausch von Schmutz- und Staubteilchen zwischen einem Arbeitsraum und dem Außenraum des Arbeitsraums verhindert oder zumindest verringert werden soll, wie beispielsweise in Verarbeitungsräumen der Lebensmittelindustrie.

Besonders geeignet ist das erfindungsgemäße Transportsystem zum Transportieren von Gegenständen in einen oder aus einem Arbeitsraum, in dem Staubschutzbedingungen aufrechtzuerhalten sind, beispielsweise in Arbeitsräumen einer Lackiererei, insbesondere Spritz- und Schleifkabinen.

Durch das erfindungsgemäße Transportsystem kann eine saubere Schnittstelle zwischen Bereichen einer Produktionsanlage mit unterschiedlichen Staubschutzbedingungen oder zwischen einem Bereich mit Staubschutzbedingungen und einem Bereich ohne Staubschutzbedingungen geschaffen werden.

Ferner werden die zu transportierenden Gegenstände während des Transports durch den Außenraum des Arbeitsraums in dem geschlossenen, transportablen Behälter weniger stark verschmutzt als bei Transport in einem offenen Behältnis.

Sind die zu transportierenden Gegenstände selbst verschmutzt, so kann durch das erfindungsgemäße Transportsystem die Verschmutzung des Außenraums des Arbeitsraums durch die zu transportierenden Gegenstände verringert werden.

Ferner ist es möglich, die zu transportierenden Gegenstände in dem Innenraum des transportablen Behälters unter Staubschutzbedingungen zwischenzulagern.

Ein Verschleppen von Schmutz und Staub aus dem Außenraum des Arbeitsraums in den Arbeitsraum hinein wird weitgehend vermieden, so daß der Aufwand und die Kosten für die Reinigung des Arbeitsraums vermindert werden können.

Handelt es sich bei dem Arbeitsraum um einen Arbeitsraum einer Lackieranlage, in dem zu lackierende Teile lackiert oder nachbearbeitet werden, so dann durch das erfindungsgemäße Transportsystem eine deutliche Verbesserung der Lackqualität und eine Reduktion der erforderlichen Nacharbeiten erzielt werden.

Zur Herstellung einer schmutz- und staubdichten Verbindung zwischen dem transportablen Behälter und dem Andockbereich des Arbeitsraums ist es von Vorteil, wenn der Andockbereich einen die Andocköffnung umgebenden Andockrahmen umfaßt.

Eine besonders dichte Verbindung zwischen dem transportablen Behälter und dem Andockbereich des Arbeitsraums kann erzielt werden, wenn der Andockrahmen des Andockbereichs eine elastische Dichtung umfaßt. Wird der transportable Behälter unter Ausübung eines Druckes auf den Andockrahmen des Andockbereichs angedockt, so ist in diesem Fall eine fluiddichte Verbindung zwischen dem transportablen Behälter und dem Andockbereich des Arbeitsraums herstellbar.

Alternativ oder ergänzend zum Vorsehen eines Andockrahmens um die Andocköffnung des Andockbereichs kann auch vorgesehen sein, daß der transportable Behälter einen die Zugangsöffnung umgebenden Andockrahmen umfaßt.

Auch der Andockrahmen des Behälters umfaßt vorzugsweise eine elastische Dichtung, um eine möglichst dichte, insbesondere eine fluiddichte, Verbindung zwischen dem transportablen Behälter und dem Andockbereich des Arbeitsraums herstellen zu können.

Der Verschluß der Andocköffnung ist vorteilhafterweise so ausgebildet, daß die Andocköffnung von dem Arbeitsraum aus geöffnet werden kann.

Um zu gewährleisten, daß die Andocköffnung stets verschlossen ist, wenn sich kein Behälter in der Andockstellung an dem Andockbereich befindet, kann vorgesehen sein, daß die Andocköffnung mittels einer selbstschließenden Tür verschließbar ist.

Eine solche selbstschließende Tür kann beispielsweise als Klapptor ausgebildet sein, welches aufgrund seines Eigengewichts in seiner Ruhestellung die Andocköffnung verschließt.

Um den transportablen Behälter in einfacher Weise in die Andockstellung an dem Andockbereich bewegen oder aus dieser Andockstellung entfernen zu können, ist bei einer bevorzugten Ausgestaltung der Erfindung vorgesehen, daß der transportable Behälter mittels an dem Behälter angeordneter Rollen verfahrbar ist.

Alternativ oder ergänzend hierzu kann auch vorgesehen sein, daß das Transportsystem ein Transportgestell zur Aufnahme des transportablen Behälters umfaßt, welches mittels an dem Transportgestell angeordneter Rollen verfahrbar ist.

Ferner kann vorgesehen sein, daß das Transportsystem ein Fahrzeug, insbesondere einen elektrischen Hubwagen, zur Aufnahme des Behälters umfaßt.

Zur Art des Verschlusses der Zugangsöffnung des transportablen Behälters wurden bislang noch keine näheren Angaben gemacht.

So kann beispielsweise ein Klapptor zum Verschließen der Zugangsöffnung des transportablen Behälters verwendet werden.

Bei einer bevorzugten Ausgestaltung der Erfindung ist jedoch vorgesehen, daß die Zugangsöffnung des transportablen Behälters mittels eines Rolltors verschließbar ist.

Besonders günstig ist es, wenn der Verschluß der Zugangsöffnung des transportablen Behälters so ausgebildet ist, daß die Zugangsöffnung in der Andockstellung des Behälters an dem Andockbereich von dem Innenraum des Arbeitsraums her geöffnet werden kann.

Um den in dem Innenraum des transportablen Behälters vorhandenen Platz optimal nutzen zu können und eine übersichtliche Anordnung der zu transportierenden Gegenstände in dem Innenraum des transportablen Behälters zu ermöglichen, umfaßt der transportable Behälter vorteilhafterweise in seinem Innenraum angeordnete Einbauten zur Aufnahme der zu transportierenden Gegenstände.

Um diese Einbauten reinigen und/oder gegen andere Einbauten austauschen zu können, welche auf den jeweils beabsichtigten Transportzweck abgestimmt sind, ist es günstig, wenn die Einbauten aus dem Innenraum des transportablen Behälters entnehmbar sind.

Häufig sind die zu transportierenden Gegenstände nicht direkt aus einem Vorraum in den Arbeitsraum hinein oder aus dem Arbeitsraum in den Vorraum hinaus zu transportieren, sondern ist ein zwischen dem Arbeitsraum und dem Vorraum angeordneter Bereitstellungsraum vorgesehen, durch den die Gegenstände zu transportieren sind und in dem diese Gegenstände zwischengelagert werden können. Dieser Bereitstellungsraum bildet einen Teil des Außenraums des Arbeitsraums. Handelt es sich bei dem Arbeitsraum um einen Staubschutzraum, so sind üblicherweise auch für den Bereitstellungsraum Staubschutzbedingungen (derselben Klasse wie im Arbeitsraum oder einer geringeren Klasse als im Arbeitsraum) vorgesehen.

Ist ein solcher Bereitstellungsraum vorhanden, so umfaßt das Transportsystem vorzugsweise ferner einen Durchgangsbereich, der in eine Außenwand des an den Arbeitsraum angrenzenden Bereitstellungsraums integriert ist und eine Durchgangsöffnung aufweist, durch die die zu transportierenden Gegenstände von außerhalb des Bereitstellungsraums in den Bereitstellungsraum einbringbar sind.

Dabei können die zu transportierenden Gegenstände bereits vor dem Einbringen in den Bereitstellungsraum in den Innenraum des transportablen Behälters eingebracht werden. In diesem Fall ist es günstig, wenn der Durchgangsbereich eine Durchgangsöffnung umfaßt, durch die der transportable Behälter von außerhalb des Bereitstellungsraums in den Bereitstellungsraum einbringbar ist.

Um einen Austausch von Schmutz- und Staubteilchen zwischen dem Bereitstellungsraum und dem Vorraum des Bereitstellungsraums weitgehend zu unterbinden, kann vorgesehen sein, daß der Durchgangsbereich einen Schleusenraum umfaßt, in den der transportable Behälter von außerhalb des Bereitstellungsraums einbringbar ist und aus dem der transportable Behälter in den Bereitstellungsraum einbringbar ist.

Dieser Schleusenraum kann dadurch von dem Bereitstellungsraum abgetrennt werden, daß der Schleusenraum eine Einrichtung zur Erzeugung eines Luftvorhanges aufweist, durch die ein den Schleusenraum von dem Bereitstellungsraum trennender Luftvorhang erzeugbar ist.

Ferner kann der Schleusenraum von dem Vorraum des Bereitstellungsraums getrennt werden, wenn der Schleusenraum eine Einrichtung zur Erzeugung eines Luftvorhanges aufweist, durch die ein den Schleusenraum von dem außerhalb des Bereitstellungsraums angeordneten Raum trennender Luftvorhang erzeugbar ist.

Alternativ oder ergänzend zum Vorsehen von Einrichtungen zur Erzeugung eines Luftvorhanges kann auch vorgesehen sein, daß der Schleusenraum eine Schleusentür aufweist, durch die der Schleusenraum von dem Bereitstellungsraum trennbar ist, und/oder eine Schleusentür, durch die der Schleusenraum von dem außerhalb des Bereitstellungsraums angeordneten Raum trennbar ist.

Bei einer bevorzugten Ausgestaltung der Erfindung ist jedoch vorgesehen, daß der transportable Behälter selbst den Bereitstellungsraum nicht verläßt, um eine Verschmutzung des Behälters außerhalb des Bereitstellungsraums zu verhindern.

In diesem Fall umfaßt der Durchgangsbereich vorteilhafterweise einen Bereitstellungsraum-Andockbereich, der eine verschließbare Andocköffnung aufweist, wobei der transportable Behälter von dem Bereitstellungsraum her so mit dem Bereitstellungsraum-Andockbereich verbindbar ist, daß bei geöffneter Zugangsöffnung des transportablen Behälters und geöffneter Andocköffnung des Bereitstellungsraum-Andockbereichs der Innenraum des Behälters von außerhalb des Bereitstellungsraums aus zugänglich und von dem Bereitstellungsraum getrennt ist.

Der transportable Behälter kann in diesem Fall in eine Andockstellung an den Bereitstellungsraum-Andockbereich gebracht werden, in der der Behälter von außerhalb des Bereitstellungsraums be- oder entladen werden kann, ohne daß Schmutz- oder Staubteilchen von außerhalb des Bereitstellungsraums in den Bereitstellungsraum oder aus dem Bereitstellungsraum in den Vorraum des Bereitstellungsraums gelangen können.

Um bei der Handhabung des transportablen Behälters, insbesondere beim Verfahren des transportablen Behälters zwischen dem Andockbereich in der Außenwand des Arbeitsraums und dem Durchgangsbereich in der Außenwand des Bereitstellungsraums, aufgewirbelten Staub zu binden und somit das Aufrechterhalten von Staubschutzbedingungen in dem Bereitstellungsraum zu erleichtern, ist es von Vorteil, wenn das Transportsystem zwischen dem Andockbereich in der Außenwand des Arbeitsraums und dem Durchgangebereich in der Außenwand des Bereitstellungsraums angeordnete Staubbindemittel umfaßt.

Vorzugsweise umfassen diese Staubbindemittel eine am Boden des Bereitstellungsraums angeordnete Staubbindefolie.

Um den transportablen Behälter zwischen zwei Transportvorgängen in dem Bereitstellungsraum unterbringen zu können oder zu transportierende Gegenstände im Innenraum des transportablen Behälters in dem Bereitstellungsraum zwischenlagern zu können, umfaßt das Transportsystem vorteilhafterweise einen in dem Bereitstellungsraum angeordneten Bereitstellungsplatz für den transportablen Behälter.

Um zu vermeiden, daß in den Arbeitsraum hinein zu transportierende Gegenstände durch Schmutzteilchen verschmutzt werden, welche zuvor von aus dem Arbeitsraum heraus transportierten Gegenständen in den Innenraum des transportablen Behälters eingebracht worden sind, kann ferner vorgesehen sein, daß das Transportsystem einen ersten transportablen Behälter zum Transportieren von Gegenständen in den Arbeitsraum und einen zweiten transportablen Behälter zum Transportieren von Gegenständen aus dem Arbeitsraum heraus umfaßt.

Der vorliegenden Erfindung liegt die weitere Aufgabe zugrunde, ein Verfahren zum Transportieren von Gegenständen in einen Arbeitsraum hinein oder aus einem Arbeitsraum heraus anzugeben, mittels dessen der Eintrag von Schmutz- und Staubteilchen aus dem Außenraum des Arbeitsraums in den Arbeitsraum hinein beim Transport der Gegenstände vermindert werden kann.

Diese Aufgabe wird erfindungsgemäß durch ein Verfahren zum Transportieren von Gegenständen in einen Arbeitsraum hinein oder aus einem Arbeitsraum heraus gelöst, bei dem
- ein geschlossener, transportabler Behälter mit einer verschließbaren Zugangsöffnung von der Außenseite des Arbeitsraums her mit einem Andockbereich, der in eine Außenwand des Arbeitsraums integriert ist und eine verschließbare Andocköffnung aufweist, verbunden wird,
- anschließend die Zugangsöffnung und die Andocköffnung geöffnet werden, so daß der Innenraum des Behälters von dem Arbeitsraum aus zugänglich wird, von dem Außenraum des Arbeitsraums jedoch getrennt ist, und
- anschließend die in den Arbeitsraum zu transportierenden Gegenstände von dem Arbeitsraum her aus dem transportablen Behälter entnommen bzw. die aus dem Arbeitsraum zu transportierenden Gegenstände von dem Arbeitsraum her in den Innenraum des transportablen Behälters eingebracht werden.

Bei dem erfindungsgemäßen Verfahren wird somit ein direkter Kontakt zwischen dem Innenraum des Arbeitsraums und dem Außenraum des Arbeitsraums vermieden, so daß beim Transport der Gegenstände weder Schmutz noch Staub in den Arbeitsraum eingebracht werden.

Besondere Ausgestaltungen des erfindungsgemäßen Verfahrens sind Gegenstand der abhängigen Ansprüche 27 bis 50, deren Vorteile bereits vorstehend im Zusammenhang mit den abhängigen Ansprüchen 2 bis 25 erläutert wurden.

Weitere Merkmale und Vorteile der Erfindung sind Gegenstand der nachfolgenden Beschreibung und zeichnerischen Darstellung eines Ausführungsbeispiels.

In den Zeichnungen zeigen:
- Fig. 1: eine schematische, teilweise geschnittene Draufsicht auf einen Arbeitsraum, einen an den Arbeitsraum angrenzenden Bereitstellungsraum und einen an den Bereitstellungsraum angrenzenden Vorraum, wobei ein transportabler Behälter in drei verschiedenen Stellungen dargestellt ist, die er in dem Bereitstellungsraum einnehmen kann;
- Fig. 2: einen schematischen Längsschnitt längs der Linie 2-2 in Fig. 1 durch einen Andockbereich, der in die Außenwand des Arbeitsraums integriert ist, wobei der transportable Behälter sich in einer Andockstellung an dem Andockbereich befindet;
- Fig. 3: eine Seitenansicht der Außenwand des Arbeitsraums und einen Schnitt durch den transportablen Behälter längs der Linie 3-3 in Fig. 1; und
- Fig. 4: einen schematischen Querschnitt längs der Linie 4-4 in Fig. 1 durch einen Andockbereich eines Durchgangsbereichs, der in die Außenwand des an den Arbeitsraum angrenzenden Bereitstellungsraums integriert ist, wobei der transportable Behälter sich in einer Andockstellung an dem Andockbereich befindet.

Gleiche oder funktional äquivalente Elemente sind in allen Figuren mit denselben Bezugszeichen bezeichnet.

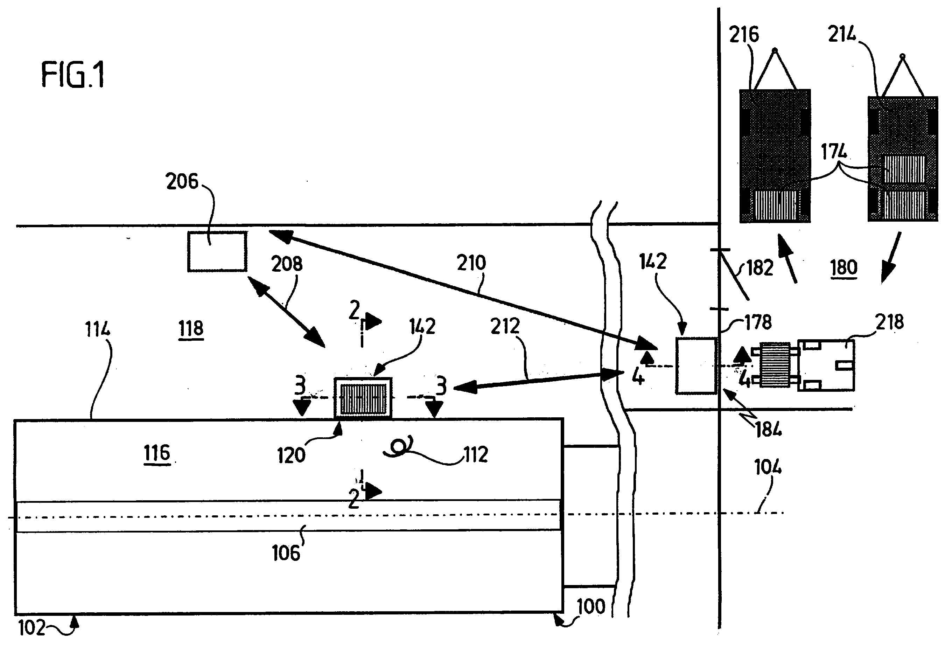

Ein in den Figuren 1 bis 3 dargestellter, als Ganzes mit 100 bezeichneter Arbeitsraum, beispielsweise der Innenraum einer Lackierstraße, umfaßt eine im wesentlichen quaderförmige Spritzkabine 102, in deren Längsrichtung 104 zu lackierende Teile, beispielsweise Automobilkarossen, auf einem Förderweg 106 mittels einer (nicht dargestellten) Fördereinrichtung durch die Spritzkabine 102 gefördert werden.

Zu beiden Seiten des Förderweges 106 ist jeweils ein aus einer Vielzahl von Gitterrosten 108 zusammengesetzter Gitterboden 110 angeordnet, der Bedienungspersonen 112 trägt, welche in der Spritzkabine 102 mittels (nicht dargestellter) Handspritzpistolen Lackierarbeiten ausführen oder Wartungsarbeiten durchführen.

Um zu verhindern, daß die Qualität der Lackierung der zu lackierenden Teile durch in der Kabinenluft vorhandene Schwebteilchen beeinträchtigt wird, werden in der Spritzkabine 102 Staubschutzbedingungen aufrechterhalten.

Staubschutzbedingungen werden hier und im folgenden durch die Angabe einer Luftfilterklasse gemäß der DIN EN 779 charakterisiert. Unter Staubschutzbedingungen einer gegebenen Filterklasse sind dabei solche Raumluftbedingungen zu verstehen, die durch Filtrieren der Raumluft mit einem Luftfilter der angegebenen Filterklasse erzeugt werden.

Unter Verwendung dieser Terminologie herrschen in der Spritzkabine Staubschutzbedingungen einer der Klassen F7 bis F9.

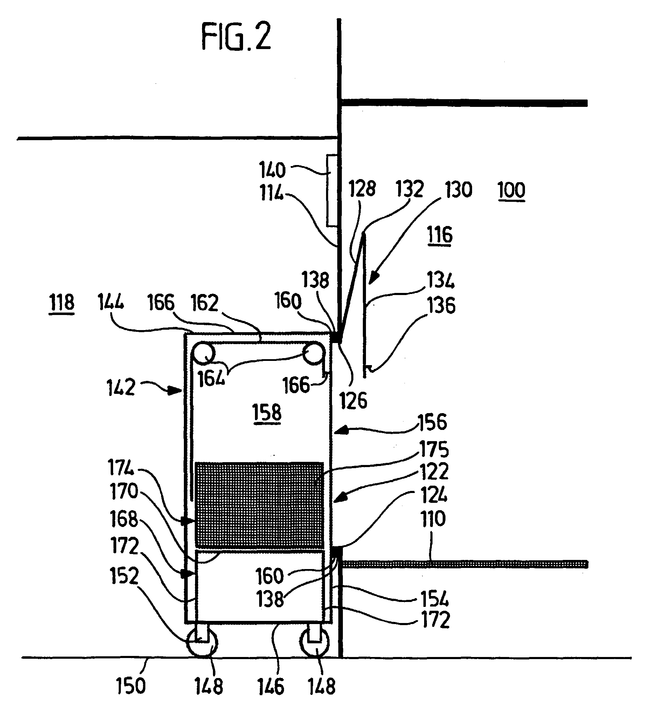

In eine Arbeitsraum-Außenwand 114, die einen Innenraum 116 der Spritzkabine 102 von einem an die Spritzkabine 102 angrenzenden Bereitstellungsraum 118 abtrennt, ist ein Arbeitsraum-Andockbereich 120 integriert, welcher eine in der Arbeitsraum-Außenwand 114 angeordnete, im wesentlichen rechtwinklige Andocköffnung 122 umfaßt (siehe Fig. 2).

Ein unterer Rand 124 der Andocköffnung 122 verläuft parallel zu dem Gitterboden 110 in einem geringen Abstand oberhalb desselben.

An einem oberen Rand 126 der Andocköffnung 122, der parallel zu dem unteren Rand 124 verläuft, ist innenraumseitig ein oberer Flügel 128 eines zweiflügeligen Klapptors 130 angelenkt, mit dessen Hilfe die Andocköffnung 122 von dem Innenraum 116 der Spritzkabine 102 aus dicht verschließbar ist.

Mittels eines Scharniers 132 ist der obere Flügel 128 des Klapptors 130 mit einem unteren Flügel 134 des Klapptors 130 verbunden, nahe dessen unteren Randes ein Handgriff 136 zur Betätigung des Klapptors 130 angeordnet ist.

Aufgrund seines Eigengewichts befindet sich das Klapptor 130 im Ruhezustand in einer Schließstellung, in der das Klapptor 130 die Andocköffnung 122 vollständig überdeckt.

Durch Anheben des Klapptors mittels des Handgriffs 136 kann das Klapptor 130 aus dieser Schließstellung in die in Fig. 2 dargestellte Offenstellung gebracht werden, in der das Klapptor 130 die Andocköffnung 122 vom Innenraum 116 der Spritzkabine 102 her freigibt. In dieser Offenstellung kann das Klapptor 130 mittels (nicht dargestellter) Arretierungsmittel arretiert werden, um eine unbeabsichtigte Rückkehr des Klapptors 130 in die Schließstellung zu verhindern.

Bereitstellungsraumseitig ist die Andocköffnung 122 von einem Andockrahmen 138 umgeben, welcher durch eine elastische Dichtung gebildet ist, die sich längs der Ränder der Andocköffnung 122 um dieselbe erstreckt und von der Arbeitsraum-Außenwand 114 aus in den Bereitstellungsraum 118 vorspringt.

Oberhalb des Arbeitsraum-Andockbereichs 120 sind an der Außenseite der Arbeitsraum-Außenwand 114 mehrere Leuchten 140 angeordnet, die der Beleuchtung des Bereitstellungsraums 118, insbesondere des an den Arbeitsraum-Andockbereich 120 angrenzenden Bereichs des Bereitstellungsraums 118, dienen.

Ferner ist in den Figuren 1 bis 3 ein geschlossener, transportabler Behälter 142 dargestellt, der in einer Andockstellung mit dem Arbeitsraum-Andockbereich 120 verbunden ist.

Der transportable Behälter 142 umfaßt ein im wesentlichen quaderförmiges Gehäuse 144 und ist mittels an dem Boden 146 des Gehäuses 144 angeordneter Rollen 148 über einen ebenen Boden 150 des Bereitstellungsraums 118 verfahrbar.

Dabei sind die, beispielsweise vier, Rollen 148 in jeweils einem Lagerbock 152 um eine horizontale Achse drehbar gelagert, während die Lagerböcke 152 ihrerseits am Boden 146 des Gehäuses 144 um eine vertikale Achse drehbar gehalten sind.

An einer Vorderseite 154 des Gehäuses 144 befindet sich eine im wesentlichen rechteckige Zugangsöffnung 156, die in Form und Größe der Andocköffnung 122 in der Arbeitsraum-Außenwand 114 entspricht und durch die der Innenraum 158 des transportablen Behälters 142 von außerhalb des Behälters 142 aus zugänglich ist.

Die Zugangsöffnung 156 ist von einem Andockrahmen 160 umgeben, welcher durch eine elastische Dichtung gebildet ist, die sich längs der Ränder der Zugangsöffnung 156 erstreckt und von der Vorderseite 154 des Gehäuses 144 aus nach vorne vorspringt.

Die Zugangsöffnung 156 des transportablen Behälters 142 ist innenraumseitig mittels eines Rolltors 162 verschließbar, das mittels (nicht dargestellter) seitlicher Führungsschienen und über zwei Umlenkwalzen 164 geführt ist, welche im Innenraum 158 des Behälters 142 nahe einer Deckenwand 166 des Gehäuses 144 jeweils um eine horizontale Achse drehbar an Innenseiten der Gehäusewand gelagert sind.

Nahe seines unteren Randes ist das Rolltor 162 mit einem Handgriff 166 versehen. Mittels dieses Handgriffes 166 kann das Rolltor 162, welches aus einem flexiblen Material oder aus einer Vielzahl um horizontale Achsen relativ zueinander verschwenkbarer Lamellen besteht, aus einer Schließstellung, in der das Rolltor 162 die Zugangsöffnung 156 des transportablen Behälters 142 vollständig überdeckt, in eine in Fig. 2 dargestellte Offenstellung gebracht werden, in der das Rolltor 162 den Zugang zu dem Innenraum 158 des Behälters 142 durch die Zugangsöffnung 156 freigibt.

Im Innenraum 158 des Behälters 142 ist ein Gestell 168 angeordnet, welches eine horizontale Tragplatte 170 und vier davon nach unten abstehende Füße 172 umfaßt, mit denen das Gestell 168 auf dem Boden 146 des Gehäuses 144 ruht.

Das Gestell 168 trägt eine im wesentlichen quaderförmige, nach oben offene Gitterbox 174, deren Seitenwände und Bodenwand durch Gitterwände 175 gebildet sind.

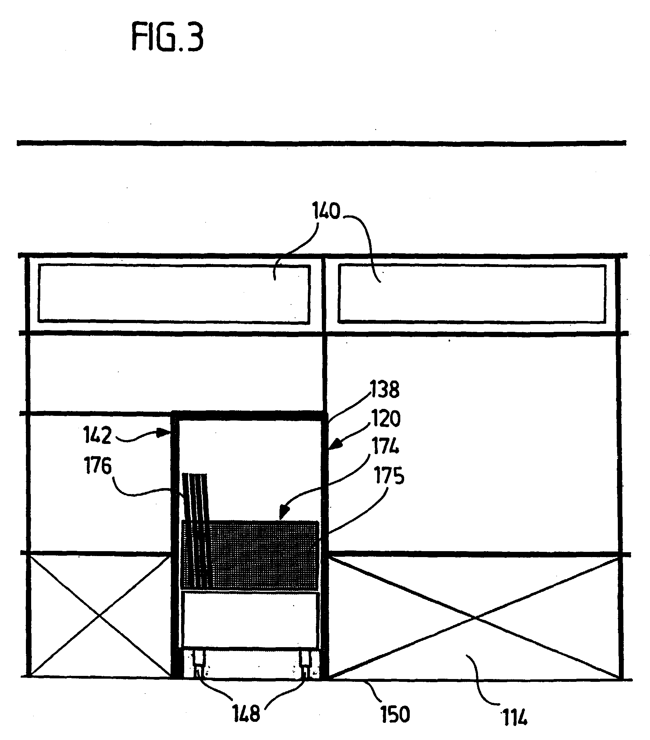

Wie aus Fig. 3 zu ersehen ist, dient die Gitterbox 174 der Aufnahme von im wesentlichen plattenförmigen Gitterrosten, beispielsweise gereinigten Gitterrosten 176, die aufrecht von oben in die Gitterbox 174 eingestellt werden und von denen vier in Fig. 3 dargestellt sind.

Die Zugangsöffnung 156 und der Andockrahmen 160 sind so ausgebildet und angeordnet, daß der Andockrahmen 160 in der Andockstellung des transportablen Behälters 142, die in den Figuren 1 bis 3 dargestellt ist, mit dem Andockrahmen 138 des Arbeitsraum-Andockbereichs 120 zur Anlage kommt und die Zugangsöffnung 156 des Behälters 142 im wesentlichen mit der Andocköffnung 122 des Arbeitsraum-Andockbereichs 120 fluchtet.

Wie aus Fig. 1 zu ersehen ist, ist der Bereitstellungsraum 118 allseitig von Begrenzungswänden umgeben. Insbesondere weist der Bereitstellungsraum 118 eine Außenwand 178 auf, durch die der Bereitstellungsraum 118 von einem an den Bereitstellungsraum 118 angrenzenden Vorraum 180 getrennt ist.

In dem Bereitstellungsraum 118 werden Staubschutzbedingungen einer der Klassen F5 bis F7 aufrechterhalten, während in dem Vorraum 180 keine Staubschutzbedingungen herrschen.

In der Außenwand 178 zwischen dem Bereitstellungsraum 118 und dem Vorraum 180 ist eine Tür 182 angeordnet, durch die der Bereitstellungsraum 118 vom Vorraum 180 aus von Bedienungspersonal betreten oder verlassen werden kann.

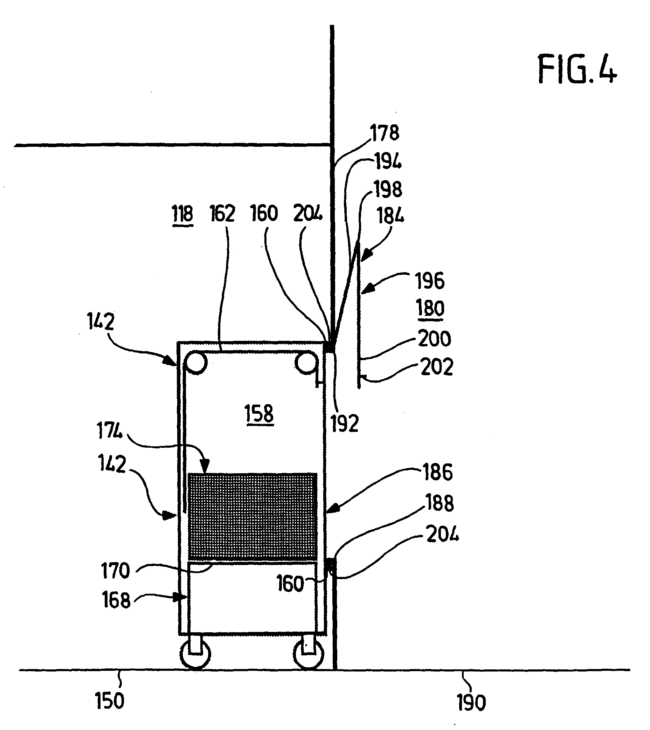

Ferner ist in die Außenwand 178 ein Bereitstellungsraum-Andockbereich 184 integriert, der im einzelnen in Fig. 4 dargestellt ist.

Dieser Bereitstellungsraum-Andockbereich 184 entspricht in seinem Aufbau im wesentlichen dem bereits vorstehend beschriebenen Arbeitsraum-Andockbereich 120.

Insbesondere umfaßt der Bereitstellungsraum-Andockbereich 184 eine im wesentlichen rechtwinklige Andocköffnung 186 in der Außenwand 178.

Ein unterer Rand 188 der Andocköffnung 186 verläuft parallel zu einem Boden 190 des Vorraums 180, welcher in derselben Ebene wie der Boden 150 des Bereitstellungsraums 118 angeordnet ist.

An einem oberen Rand 192 der Andocköffnung 186 ist ein oberer Flügel 194 eines zweiflügeligen Klapptors 196 angelenkt, durch das die Andocköffnung 186 vorraumseitig verschließbar ist.

Über ein Scharnier 198 ist der obere Flügel 194 mit einem unteren Flügel 200 des Klapptors 196 verbunden, nahe dessen unteren Randes ein Handgriff 202 angeordnet ist, mittels dessen das Klapptor 196 betätigt werden kann.

Mittels des Handgriffs 202 kann das Klapptor 196 aus einer Schließstellung, in der das Klapptor 196 die Andocköffnung 186 überdeckt, in eine in Fig. 4 dargestellte Offenstellung gebracht werden, in der das Klapptor 196 den Zugang zu der Andocköffnung 186 freigibt.

In der Schließstellung ist das Klapptor 196 mittels (nicht dargestellter) Arretierungsmittel arretierbar, um zu verhindern, daß das Klapptor 196 unbeabsichtigt in die Schließstellung zurückkehrt.

Bereitstellungsraumseitig ist die Andocköffnung 186 von einem Andockrahmen 204 umgeben, welcher aus einer elastischen Dichtung gebildet ist, die sich längs der Ränder der Andocköffnung 186 erstreckt und von der Innenseite der Außenwand 178 aus in den Bereitstellungsraum 118 vorspringt.

Die Andocköffnung 186 und der Andockrahmen 204 des Bereitstellungsraum-Andockbereichs 184 sind so ausgebildet und angeordnet, daß der transportable Behälter 142 in eine in Fig. 4 dargestellte Andockstellung gebracht werden kann, in der der Andockrahmen 160 des Behälters 142 zur Anlage mit dem Andockrahmen 204 des Bereitstellungsraum-Andockbereiches 184 kommt und die Zugangsöffnung 156 des Behälters 142 im wesentlichen mit der Andocköffnung 186 des Bereitstellungsraum-Andockbereiches 184 fluchtet.

Wie aus Fig. 1 zu ersehen ist, ist in dem Bereitstellungsraum 118 ferner ein Bereitstellungsplatz 206 für den transportablen Behälter 142 vorgesehen, der von dem Arbeitsraum-Andockbereich 120 und von dem Bereitstellungsraum-Andockbereich 184 beabstandet ist.

Der transportable Behälter 142 ist in dem Bereitstellungsraum 118 zwischen dem Bereitstellungsplatz 206 und dem Arbeitsraum-Andockbereich 120 längs des Doppelpfeils 208, zwischen dem Bereitstellungsplatz 206 und dem Bereitstellungsraum-Andockbereich 184 längs des Doppelpfeils 210 und zwischen dem Arbeitsraum-Andockbereich 120 und dem Bereitstellungsraum-Andockbereich 184 längs des Doppelpfeils 212 verfahrbar.

Im Bereich des Bereitstellungsplatzes 206, des Arbeitsraum-Andockbereiches 120, des Bereitstellungsraum-Andockbereiches 184 und der Fahrwege zwischen den genannten Bereichen ist der Boden 150 des Bereitstellungsraums 118 mit (nicht dargestellten) Staubbindefolien ausgelegt, um im Zuge der Handhabung des transportablen Behälters 142 aufgewirbelten Staub umgehend zu binden und somit die Staubschutzbedingungen in dem Bereitstellungsraum 118 aufrechtzuerhalten.

Diese Staubbindefolien bestehen beispielsweise aus aufeinandergestapelten, mit einem Staubbindelack versehenen PVC-Folien. Die einzelnen PVC-Folien dieses Folienstapels können nacheinander abgezogen werden, um jeweils eine neue Staubbindelack-Oberfläche zur Aufnahme von Staub zur Verfügung zu stellen.

In dem Vorraum 180 sind nahe des Bereitstellungsraum-Andockbereiches 184 ein Abstellplatz für einen zu entladenden Plattenwagen 214 und ein Abstellplatz für einen zu beladenden Plattenwagen 216 vorgesehen.

Beide Plattenwagen 214 und 216 weisen jeweils eine Ladefläche zur Aufnahme von mehreren Gitterboxen 174 auf.

Ferner ist in dem Vorraum 180 ein Gabelstapler 218 vorhanden, mit dessen Hilfe jeweils eine Gitterbox 174 von dem zu entladenden Plattenwagen 214 zu dem Bereitstellungsraum-Andockbereich 184 oder jeweils eine Gitterbox 174 von dem Bereitstellungsraum-Andockbereich 184 zu dem zu beladenden Plattenwagen 216 transportierbar ist.

Der transportable Behälter 142, der Arbeitsraum-Andockbereich 120 und der Bereitstellungsraum-Andockbereich 184 bilden zusammen ein Transportsystem zum Transportieren von Gegenständen in den Arbeitsraum 100 oder aus demselben heraus.

Mit diesem Transportsystem werden ein Verfahren zum Transportieren von Gegenständen, beispielsweise von gereinigten Gitterrosten 176, in den Arbeitsraum 100 hinein und ein Verfahren zum Transportieren von Gegenständen, beispielsweise verschmutzten Gitterrosten 108, aus dem Arbeitsraum 100 heraus wie folgt durchgeführt:

Ein zu entladender Plattenwagen 214 mit mehreren Gitterboxen 174, die mit gereinigten Gitterrosten 176 befüllt sind, und ein zu beladender Plattenwagen 216, dessen Ladefläche zunächst leer ist, werden auf den dafür vorgesehenen Abstellplätzen im Vorraum 180 abgestellt.

Der transportable Behälter 142 wird von einer Bedienungsperson von dem Bereitstellungsplatz 206, wo der Behälter 142 zwischen Transportvorgängen abgestellt wird, zu dem Bereitstellungsraum-Andockbereich 184 gefahren und in die in Fig. 4 dargestellte Andockstellung an diesen Andockbereich gebracht. Der Innenraum 158 des Behälters 142 ist, abgesehen von dem Gestell 168, zunächst leer.

Nun werden von dem Vorraum 180 aus zunächst das Klapptor 196 und dann das Rolltor 162 des Behälters 142 geöffnet, so daß der Innenraum 158 des Behälters 142 von dem Vorraum 180 aus zugänglich, von dem Innenraum des Bereitstellungsraums 118 jedoch getrennt ist.

Anschließend wird mittels des Gabelstaplers 218 eine mit gereinigten Gitterrosten 176 befüllte Gitterbox 174 von dem Plattenwagen 214 abgehoben, durch die Andocköffnung 186 und die Zugangsöffnung 156 in den Innenraum 158 des transportablen Behälters 142 eingebracht und dort auf der Tragplatte 170 des Gestells 168 abgestellt.

Darauf werden von dem Vorraum 180 aus das Rolltor 162 und das Klapptor 196 geschlossen.

Der geschlossene transportable Behälter 142 wird von einer Bedienungsperson von dem Bereitstellungsraum-Andockbereich 184 zu dem Arbeitsraum-Andockbereich 120 gefahren und dort in die in den Figuren 2 und 3 dargestellte Andockstellung gebracht, in der der Andockrahmen 160 des Behälters 142 an dem Andockrahmen 138 des Arbeitsraum-Andockbereiches 120 anliegt.

Anschließend werden von dem Innenraum 116 der Spritzkabine 102 aus das Klapptor 130 und das Rolltor 162 geÖffnet, so daß der Innenraum 158 des Behälters 142 von dem Innenraum 116 der Spritzkabine 102 aus zugänglich, von dem Innenraum des Bereitstellungsraums 118 jedoch getrennt ist.

Darauf werden die gereinigten Gitterroste 176 von einer oder mehreren Bedienungspersonen 112 aus der in dem Behälter 142 befindlichen Gitterbox 174 entnommen und, beispielsweise mittels einer Sackkarre, in der Spritzkabine 102 zu einer Stelle transportiert, an der verschmutzte Gitterroste des Gitterbodens 110 gegen gereinigte Gitterroste ausgetauscht werden sollen.

Nach Austausch der gereinigten Gitterroste 176 gegen verschmutzte Gitterroste 108 werden die letzteren zu dem Arbeitsraum-Andockbereich 120 zurücktransportiert, durch die Andocköffnung 122 und die Zugangsöffnung 156 in den Innenraum 158 des Behälters 142 eingebracht und dort in die Gitterbox 174 eingestellt.

Anschließend werden von dem Innenraum 116 der Spritzkabine 102 aus das Rolltor 162 und das Klapptor 130 geschlossen.

Der geschlossene transportable Behälter 142 wird von einer Bedienungsperson von dem Arbeitsraum-Andockbereich 120 zu dem Bereitstellungsraum-Andockbereich 184 zurückgefahren und dort wiederum in die in Fig. 4 dargestellte Andockstellung gebracht, in der der Andockrahmen 160 des Behälters 142 an dem Andockrahmen 204 des Bereitstellungsraum-Andockbereiches 184 anliegt.

Anschließend werden von dem Vorraum 180 aus das Klapptor 196 und das Rolltor 162 geöffnet, so daß der Innenraum 158 des Behälters 142 von dem Vorraum 180 aus zugänglich, von dem Innenraum des Bereitstellungsraums 118 jedoch getrennt ist.

Anschließend wird die mit verschmutzten Gitterrosten 108 gefüllte Gitterbox 174 mittels des Gabelstaplers 218 von der Tragplatte 170 des Gestells 168 abgehoben, zu dem zu beladenden Plattenwagen 216 transportiert und auf dessen Ladefläche abgestellt.

Auf die vorstehend beschriebene Weise werden die mit gereinigten Gitterrosten 176 gefüllten Gitterboxen 174 von dem zu entladenden Plattenwagen 214 nacheinander zu dem Arbeitsraum-Andockbereich 120 transportiert, dort entladen und mit verschmutzten Gitterrosten 108 erneut beladen sowie zu dem zu beladenden Plattenwagen 216 transportiert.

Nach der Entnahme der letzten Gitterbox 174 aus dem Innenraum 158 des Behälters 142 an dem Bereitstellungsraum-Andockbereich 184 wird der transportable Behälter 142 nicht mehr beladen. Vielmehr wird der Behälter 142, nachdem das Rolltor 162 und das Klapptor 196 von dem Vorraum 180 aus geschlossen worden sind, zu dem Bereitstellungsplatz 206 zurückgefahren, wo er bis zur Durchführung des nächsten Transportvorgangs verbleibt.

Durch das Andocken des transportablen Behälters 142 an dem Arbeitsraum-Andockbereich 120 mittels des andockbereichsseitigen Andockrahmens 138 und des behälterseitigen Andockrahmens 160 wird erreicht, daß weder Staub noch sonstige Verschmutzungen aus dem Bereitstellungsraum 118 in die Spritzkabine 102 gelangen.

Durch das Andocken des transportablen Behälters 142 an den Bereitstellungsraum-Andockbereich 184 mittels des andockbereichsseitigen Andockrahmens 204 und des behälterseitigen Andockrahmens 160 wird verhindert, daß Staub oder sonstige Schmutzteilchen aus dem Innenraum 158 des Behälters 142 oder aus dem Vorraum 180 in den Bereitstellungsraum 118 gelangen können.

Dadurch, daß die Zugangsöffnung 156 des Behälters 142 während des Transports zwischen dem Arbeitsraum-Andockbereich 120 und dem Bereitstellungsraum-Andockbereich 184 verschlossen ist, wird erreicht, daß weder Staub noch sonstige Schmutzteilchen aus dem Innenraum 158 des Behälters 142 in den Bereitstellungsraum 118 gelangen können.

Infolgedessen können die Staubschutzbedingungen in dem Bereitstellungsraum 118 und in dem Arbeitsraum 100 auch während des Transports von Gegenständen durch den Bereitstellungsraum 118 in den Arbeitsraum 100 hinein oder aus dem Arbeitsraum 100 durch den Bereitstellungsraum 118 hinaus ohne weiteres aufrechterhalten werden.

Um zu vermeiden, daß die in die Spritzkabine 102 zu transportierenden gereinigten Gitterroste 176 durch von den verschmutzten Gitterrosten 108 in den Innenraum 158 des Behälters 142 eingebrachten Schmutzteilchen verschmutzt werden, kann auch vorgesehen sein, daß das Transportsystem mindestens zwei transportable Behälter 142 umfaßt, von denen einer ausschließlich zum Transport von gereinigten Gitterrosten 176 von dem Bereitstellungsraum-Andockbereich 184 zu dem Arbeitsraum-Andockbereich 120 und ein anderer ausschließlich zum Transport von verschmutzten Gitterrosten 108 von dem Arbeitsraum-Andockbereich 120 zu dem Bereitstellungsraum-Andockbereich 184 benutzt wird.

In diesem Fall ist für jeden der transportablen Behälter 142 ein Bereitstellungsplatz 206 innerhalb des Bereitstellungsraums 118 vorzusehen.

Außer dem beispielhaft beschriebenen Austausch von Gitterrosten kann das vorstehend beschriebene Transportsystem auch bei jedem anderen Transport von Gegenständen in den Arbeitsraum 100 hinein oder aus demselben heraus zum Einsatz kommen.

Beispielsweise können in der Spritzkabine 102 benötigte Lackspritzpistolen und Spritzschläuche zu Reinigungs- und/oder Wartungszwecken ausgetauscht werden.

Ferner kann Serviceausrüstung für die Wartung von Lackiereinrichtungen mittels des Transportsystems aus dem Vorraum 180 in den Arbeitsraum 100 und aus diesem wieder zurück transportiert werden.

Verschmutzte Schuhe, Lappen und sonstiger Abfall können mittels des Transportsystems aus dem Arbeitsraum 100 heraus transportiert werden.

Insbesondere können Maskierungen aus Papier, die dazu verwendet werden, nicht zu lackierende Bereiche der zu lackierenden Teile abzudecken, mittels des Transportsystems aus dem Arbeitsraum 100 in den Vorraum 180 und von dort zu einer zentralen Entsorgungsstelle, die unabhängig von der Ausgestaltung der Spritzkabine 102 planbar ist, gebracht werden.

Umfaßt der Arbeitsraum 100 alternativ oder ergänzend zu der Spritzkabine 102 eine Schleifkabine, so kann in der Schleifkabine benötigtes Material, beispielsweise Schleifpapier, Handschuhe und Vorrichtungsteile, mittels des Transportsystems aus dem Vorraum 180 in die Schleifkabine transportiert werden. In umgekehrter Richtung können benutzte Lappen und sonstiger Abfall mittels des Transportsystems aus der Schleifkabine in den Vorraum 180 und von dort zu einer geeigneten Entsorgungsstelle transportiert werden.

Für jede der vorstehend genannten Transportaufgaben kann jeweils ein transportabler Behälter 142 benutzt werden, der hinsichtlich Größe, Stabilität und der in seinem Innenraum 158 vorgesehenen Einbauten optimal auf die jeweils zu transportierenden Gegenstände abgestimmt ist.

Es kann jedoch auch vorgesehen sein, daß ein und derselbe transportable Behälter 142 für verschiedene Transportaufgaben eingesetzt wird.

Um auch in diesem Falle den Innenraum 158 des Behälters 142 optimal für die jeweils zu transportierenden Gegenstände einrichten zu können, ist vorgesehen, daß die Einbauten im Innenraum 158 des transportablen Behälters 142 entnehmbar und gegen andere Einbauten austauschbar sind.

So kann beispielsweise das in den Figuren 2 bis 4 dargestellte Gestell 168 zur Aufnahme einer Gitterbox 174 bei geöffnetem Rolltor 162 durch die Zugangsöffnung 156 des Behälters 142 entnommen und durch ein anderes Gestell, das beispielsweise mit Halterungen zur Aufnahme von Spritzschläuchen versehen ist, ersetzt werden.

Bei der vorstehend beschriebenen Ausführungsform des Transportsystems weist der transportable Behälter 142 selbst Rollen 148 auf, um innerhalb des Bereitstellungsraums 118 verfahren werden zu können.

Alternativ hierzu kann vorgesehen sein, daß der transportable Behälter als Container ausgebildet ist, der auf ein Transportgestell mit Rollen aufgesetzt oder mittels eines anderen Transportmittels, beispielsweise eines elektrischen Hubwagens, innerhalb des Bereitstellungsraums 118 bewegt werden kann.

Ferner ist bei der vorstehend beschriebenen Ausführungsform des Transportsystems vorgesehen, daß der transportable Behälter 142 stets innerhalb des Bereitstellungsraums 118 verbleibt. Alternativ hierzu kann auch vorgesehen sein, daß der transportable Behälter 142 außerhalb des Bereitstellungsraums 118 mit den in den Arbeitsraum 100 zu transportierenden Gegenständen beladen und von dem Vorraum 180 über einen Schleusenraum in den Bereitstellungsraum 118 eingebracht wird. In umgekehrter Richtung kann der mit Gegenständen aus dem Arbeitsraum 100 beladene transportable Behälter 142 aus dem Bereitstellungsraum 118 durch den Schleusenraum in den Vorraum 180 gebracht werden.

In diesem Fall ersetzt der Schleusenraum den Bereitstellungsraum-Andockbereich 184, der in den Figuren 1 und 4 dargestellt ist.

Der zwischen dem Vorraum 180 und dem Bereitstellungsraum 118 vorgesehene Schleusenraum kann als geschlossene Schleusenkammer ausgebildet sein, die über eine verschließbare Verbindungsöffnung mit dem Vorraum 180 und über eine weitere verschließbare Verbindungsöffnung mit dem Bereitstellungsraum 118 verbunden ist. In diesem Fall wird zum Einbringen des transportablen Behälters 142 von dem Vorraum 180 in den Bereitstellungsraum 118 zunächst bei geschlossener Verbindungsöffnung zwischen dem Bereitstellungsraum 118 und dem Schleusenraum die Verbindungsöffnung zwischen dem Vorraum 180 und dem Schleusenraum geöffnet und der transportable Behälter aus dem Vorraum in den Schleusenraum eingebracht. Darauf wird die Verbindungsöffnung zwischen dem Vorraum und dem Schleusenraum geschlossen, und nach Öffnen der Verbindungsöffnung zwischen dem Bereitstellungsraum und dem Schleusenraum wird der transportable Behälter in den Bereitstellungsraum gebracht. Der Transport des Behälters von dem Bereitstellungsraum in den Vorraum erfolgt dabei in entsprechender Weise in umgekehrter Richtung.

Statt als Schleusenkammer mit verschließbaren Verbindungsöffnungen kann der Schleusenraum auch zum Bereitstellungsraum und zum Vorraum hin offen ausgestaltet sein, wobei an der Verbindungsöffnung zwischen dem Bereitstellungsraum und dem Schleusenraum und an der Verbindungsöffnung zwischen dem Vorraum und dem Schleusenraum jeweils ein Luftvorhang oder Luftschleier erzeugt wird, der dem transportablen Behälter, nicht jedoch Staub- und weiteren Schwebeteilchen den Durchtritt in den oder aus dem Schleusenraum erlaubt. In diesem Fall kann der transportable Behälter einfach durch den Schleusenraum hindurchgeschoben werden, ohne daß Verbindungsöffnungen zwischen dem Schleusenraum und dem Bereitstellungsraum einerseits und zwischen dem Vorraum und dem Schleusenraum andererseits geöffnet oder geschlossen werden müssen.

## Patentansprüche

1. Transportsystem zum Transportieren von Gegenständen in einen Arbeitsraum (100) hinein oder aus einem Arbeitsraum (100) heraus, umfassend
- einen geschlossenen, transportablen Behälter (142) mit einer verschließbaren Zugangsöffnung (156) und
- einen Andockbereich (120), der in eine Außenwand (114) des Arbeitsraums (100) integriert ist und eine verschließbare Andocköffnung (122) aufweist,
wobei der transportable Behälter (142) von der Außenseite des Arbeitsraums (100) her so mit dem Andockbereich (120) verbindbar ist, daß bei geöffneter Zugangsöffnung (156) und geöffneter Andocköffnung (122) der Innenraum (158) des Behälters (142) von dem Arbeitsraum (100) aus zugänglich und von dem Außenraum (118) des Arbeitsraums (100) getrennt ist.

2. Transportsystem nach Anspruch 1, dadurch gekennzeichnet, daß der Andockbereich (120) einen die Andocköffnung (122) umgebenden Andockrahmen (138) umfaßt.

3. Transportsystem nach Anspruch 2, dadurch gekennzeichnet, daß der Andockrahmen (138) des Andockbereichs (120) eine elastische Dichtung umfaßt.

4. Transportsystem nach einem der Ansprüche 1 bis 3, dadurch gekennzeichnet, daß der transportable Behälter (142) einen die Zugangsöffnung (156) umgebenden Andockrahmen (160) umfaßt.

5. Transportsystem nach Anspruch 4, dadurch gekennzeichnet, daß der Andockrahmen (160) des Behälters (142) eine elastische Dichtung umfaßt.

6. Transportsystem nach einem der Ansprüche 1 bis 5, dadurch gekennzeichnet, daß die Andocköffnung (122) mittels einer selbstschließenden Tür verschließbar ist.

7. Transportsystem nach Anspruch 6, dadurch gekennzeichnet, daß die selbstschließende Tür als Klapptor (130) ausgebildet ist, welches in seiner Ruhestellung die Andocköffnung (122) verschließt.

8. Transportsystem nach einem der Ansprüche 1 bis 7, dadurch gekennzeichnet, daß der transportable Behälter (142) mittels an dem Behälter (142) angeordneter Rollen (148) verfahrbar ist.

9. Transportsystem nach einem der Ansprüche 1 bis 8, dadurch gekennzeichnet, daß das Transportsystem ein Transportgestell zur Aufnahme des transportablen Behälters umfaßt, welches mittels an dem Transportgestell angeordneter Rollen verfahrbar ist.

10. Transportsystem nach einem der Ansprüche 1 bis 9, dadurch gekennzeichnet, daß das Transportsystem ein Fahrzeug, insbesondere einen elektrischen Hubwagen, zur Aufnahme des Behälters umfaßt.

11. Transportsystem nach einem der Ansprüche 1 bis 10, dadurch gekennzeichnet, daß die Zugangsöffnung (156) des transportablen Behälters (142) mittels eines Rolltors (162) verschließbar ist.

12. Transportsystem nach einem der Ansprüche 1 bis 11, dadurch gekennzeichnet, daß der transportable Behälter (142) in seinem Innenraum (158) angeordnete Einbauten (168) zur Aufnahme der zu transportierenden Gegenstände umfaßt.

13. Transportsystem nach Anspruch 12, dadurch gekennzeichnet, daß die Einbauten (168) aus dem Innenraum (158) des transportablen Behälters (142) entnehmbar sind.

14. Transportsystem nach einem der Ansprüche 1 bis 13, dadurch gekennzeichnet, daß das Transportsystem einen Durchgangsbereich umfaßt, der in eine Außenwand (178) eines an den Arbeitsraum (100) angrenzenden Bereitstellungsraums (118) integriert ist und eine Durchgangsöffnung (186) aufweist, durch die die zu transportierenden Gegenstände von außerhalb des Bereitstellungsraums (118) in den Bereitstellungsraum (118) einbringbar sind.

15. Transportsystem nach Anspruch 14, dadurch gekennzeichnet, daß der Durchgangsbereich eine Durchgangsöffnung umfaßt, durch die der transportable Behälter von außerhalb des Bereitstellungsraums in den Bereitstellungsraum einbringbar ist.

16. Transportsystem nach Anspruch 15, dadurch gekennzeichnet, daß der Durchgangsbereich einen Schleusenraum umfaßt, in den der transportable Behälter von außerhalb des Bereitstellungsraums einbringbar ist und aus dem der transportable Behälter in den Bereitstellungsraum einbringbar ist.

17. Transportsystem nach Anspruch 16, dadurch gekennzeichnet, daß der Schleusenraum eine Einrichtung zur Erzeugung eines Luftvorhanges aufweist, durch die ein den Schleusenraum von dem Bereitstellungsraum trennender Luftvorhang erzeugbar ist.

18. Transportsystem nach einem der Ansprüche 16 oder 17, dadurch gekennzeichnet, daß der Schleusenraum eine Einrichtung zur Erzeugung eines Luftvorhanges aufweist, durch die ein den Schleusenraum von einem außerhalb des Bereitstellungsraums angeordneten Raum trennender Luftvorhang erzeugbar ist.

19. Transportsystem nach Anspruch 16, dadurch gekennzeichnet, daß der Schleusenraum eine Schleusentür aufweist, durch die der Schleusenraum von dem Bereitstellungsraum trennbar ist.

20. Transportsystem nach einem der Ansprüche 16 oder 19, dadurch gekennzeichnet, daß der Schleusenraum eine Schleusentür aufweist, durch die der Schleusenraum von einem außerhalb des Bereitstellungsraums angeordneten Raum trennbar ist.

21. Transportsystem nach Anspruch 14, dadurch gekennzeichnet, daß der Durchgangsbereich einen Bereitstellungsraum-Andockbereich (184) umfaßt, der eine verschließbare Andocköffnung (186) aufweist, wobei der transportable Behälter (142) von dem Bereitstellungsraum (118) her so mit dem Bereitstellungsraum-Andockbereich (184) verbindbar ist, daß bei geöffneter Zugangsöffnung (156) des transportablen Behälters (142) und geöffneter Andocköffnung (186) des Bereitstellungsraum-Andockbereichs (184) der Innenraum (158) des Behälters (142) von außerhalb des Bereitstellungsraums (118) aus zugänglich und von dem Bereitstellungsraum (118) getrennt ist.

22. Transportsystem nach einem der Ansprüche 14 bis 21, dadurch gekennzeichnet, daß das Transportsystem zwischen dem Andockbereich (120) in der Außenwand (114) des Arbeitsraums (100) und dem Durchgangsbereich (184) in der Außenwand (178) des Bereitstellungsraums (118) angeordnete Staubbindemittel umfaßt.

23. Transportsystem nach Anspruch 22, dadurch gekennzeichnet, daß die Staubbindemittel eine am Boden des Bereitstellungsraums (118) angeordnete Staubbindefolie umfassen.

24. Transportsystem nach einem der Ansprüche 14 bis 23, dadurch gekennzeichnet, daß das Transportsystem einen in dem Bereitstellungsraum (118) angeordneten Bereitstellungsplatz (206) für den transportablen Behälter (142) umfaßt.

25. Transportsystem nach einem der Ansprüche 1 bis 24, dadurch gekennzeichnet, daß das Transportsystem einen ersten transportablen Behälter zum Transportieren von Gegenständen in den Arbeitsraum (100) und einen zweiten transportablen Behälter zum Transportieren von Gegenständen aus dem Arbeitsraum (100) heraus umfaßt.

26. Verfahren zum Transportieren von Gegenständen in einen Arbeitsraum hinein oder aus einem Arbeitsraum heraus, bei dem
- ein geschlossener, transportabler Behälter mit einer verschließbaren Zugangsöffnung von der Außenseite des Arbeitsraums her mit einem Andockbereich, der in eine Außenwand des Arbeitsraums integriert ist und eine verschließbare Andocköffnung aufweist, verbunden wird,
- anschließend die Zugangsöffnung und die Andocköffnung geöffnet werden, so daß der Innenraum des Behälters von dem Arbeitsraum aus zugänglich wird, von dem Außenraum des Arbeitsraums jedoch getrennt ist, und
- anschließend die in den Arbeitsraum zu transportierenden Gegenstände von dem Arbeitsraum her aus dem transportablen Behälter entnommen bzw. die aus dem Arbeitsraum zu transportierenden Gegenstände von dem Arbeitsraum her in den Innenraum des transportablen Behälters eingebracht werden.

27. Verfahren nach Anspruch 26, dadurch gekennzeichnet, daß der transportable Behälter und der Andockbereich mittels eines die Andocköffnung umgebenden Andockrahmens miteinander verbunden werden.

28. Verfahren nach Anspruch 27, dadurch gekennzeichnet, daß ein eine elastische Dichtung umfassender Andockrahmen des Andockbereichs verwendet wird.

29. Verfahren nach einem der Ansprüche 26 bis 28, dadurch gekennzeichnet, daß der transportable Behälter und der Andockbereich mittels eines die Zugangsöffnung umgebenden Andockrahmens miteinander verbunden werden.

30. Verfahren nach Anspruch 29, dadurch gekennzeichnet, daß ein eine elastische Dichtung umfassender Andockrahmen des Behälters verwendet wird.

31. Verfahren nach einem der Ansprüche 26 bis 30, dadurch gekennzeichnet, daß die Andocköffnung mittels einer selbstschließenden Tür verschlossen wird.

32. Verfahren nach Anspruch 31, dadurch gekennzeichnet, daß als selbstschließende Tür ein Klapptor verwendet wird, welches in seiner Ruhestellung die Andocköffnung verschließt.

33. Verfahren nach einem der Ansprüche 26 bis 32, dadurch gekennzeichnet, daß der transportable Behälter mittels an dem Behälter angeordneter Rollen zu dem Andockbereich hin oder von dem Andockbereich weg verfahren wird.

34. Verfahren nach einem der Ansprüche 26 bis 33, dadurch gekennzeichnet, daß der transportable Behälter mittels eines Transportgestells, welches mittels an dem Transportgestell angeordneter Rollen verfahrbar ist und zur Aufnahme des transportablen Behälters ausgebildet ist, zu dem Andockbereich hin oder von dem Andockbereich weg verfahren wird.

35. Verfahren nach einem der Ansprüche 26 bis 34, dadurch gekennzeichnet, daß der transportable Behälter mittels eines Fahrzeugs, insbesondere eines elektrischen Hubwagens, welches zur Aufnahme des Behälters ausgebildet ist, zu dem Andockbereich hin oder von dem Andockbereich weg verfahren wird.

36. Verfahren nach einem der Ansprüche 26 bis 35, dadurch gekennzeichnet, daß die Zugangsöffnung des transportablen Behälters mittels eines Rolltors verschlossen wird.

37. Verfahren nach einem der Ansprüche 26 bis 36, dadurch gekennzeichnet, daß die zu transportierenden Gegenstände in dem Innenraum des transportablen Behälters mittels in diesem Innenraum angeordneter Einbauten aufgenommen werden.

38. Verfahren nach Anspruch 37, dadurch gekennzeichnet, daß die Einbauten in dem Innenraum des transportablen Behälters vor einem Transportvorgang gegen für die jeweils zu transportierenden Gegenstände vorgesehene Einbauten ausgetauscht werden.

39. Verfahren nach einem der Ansprüche 26 bis 38, dadurch gekennzeichnet, daß die zu transportierenden Gegenstände von außerhalb eines an den Arbeitsraum angrenzenden Bereitstellungsraums mittels eines Durchgangsbereichs, der in eine Außenwand des Bereitstellungsraums integriert ist und eine Durchgangsöffnung für die zu transportierenden Gegenstände aufweist, in den Bereitstellungsraum eingebracht werden.

40. Verfahren nach Anspruch 39, dadurch gekennzeichnet, daß der transportable Behälter von außerhalb des Bereitstellungsraums durch die Durchgangsöffnung des Durchgangsbereichs in den Bereitstellungsraum eingebracht wird.

41. Verfahren nach Anspruch 40, dadurch gekennzeichnet, daß der transportable Behälter von außerhalb des Bereitstellungsraums in einen Schleusenraum des Durchgangsbereichs und aus dem Schleusenraum des Durchgangsbereichs in den Bereitstellungsraum eingebracht wird.

42. Verfahren nach Anspruch 41, dadurch gekennzeichnet, daß ein den Schleusenraum von dem Bereitstellungsraum trennender Luftvorhang erzeugt wird.

43. Verfahren nach einem der Ansprüche 41 oder 42, dadurch gekennzeichnet, daß ein den Schleusenraum von einem außerhalb des Bereitstellungsraum angeordneten Raum trennender Luftvorhang erzeugt wird.

44. Verfahren nach Anspruch 41, dadurch gekennzeichnet, daß der Schleusenraum mittels einer Schleusentür von dem Bereitstellungsraum getrennt wird.

45. Verfahren nach einem der Ansprüche 41 oder 44, dadurch gekennzeichnet, daß der Schleusenraum mittels einer Schleusentür von einem außerhalb des Bereitstellungsraums angeordneten Raum getrennt wird.

46. Verfahren nach Anspruch 39, dadurch gekennzeichnet, daß der transportable Behälter von dem Bereitstellungsraum her mit einem Bereitstellungsraum-Andockbereich, der eine verschließbare Andocköffnung aufweist, verbunden wird, und anschließend die Zugangsöffnung des transportablen Behälters und die Andocköffnung des Bereitstellungsraum-Andockbereichs geöffnet werden, so daß der Innenraum des Behälters von außerhalb des Bereitstellungsraums aus zugänglich und von dem Bereitstellungsraum getrennt ist.

47. Verfahren nach einem der Ansprüche 39 bis 46, dadurch gekennzeichnet, daß in dem Bereitstellungsraum Staub mittels zwischen dem Andockbereich in der Außenwand des Arbeitsraums und dem Durchgangsbereich in der Außenwand des Bereitstellungsraums angeordneter Staubbindemittel gebunden wird.

48. Verfahren nach Anspruch 47, dadurch gekennzeichnet, daß eine am Boden des Bereitstellungsraums angeordnete Staubbindefolie umfassende Staubbindemittel verwendet werden.

49. Verfahren nach einem der Ansprüche 39 bis 48, dadurch gekennzeichnet, daß der transportable Behälter zwischen zwei Transportvorgängen an einem in dem Bereitstellungsraum angeordneten Bereitstellungsplatz abgestellt wird.

50. Verfahren nach einem der Ansprüche 26 bis 49, dadurch gekennzeichnet, daß die in den Arbeitsraum hinein zu transportierenden Gegenstände mittels eines ersten transportablen Behälters und die aus dem Arbeitsraum heraus zu transportierenden Gegenstände mittels eines zweiten transportablen Behälters transportiert werden.
